# FASCICULE DE BREVET EUROPEEN

(11) **EP 3 774 207 B1**
(45) Date de publication et mention de la délivrance du brevet: **07.06.2023**
(21) Numéro de dépôt: 19718776.8
(22) Date de dépôt: 15.03.2019
(51) Int. Cl.: B25J 15/06, H01L 21/683, B25J 11/00

(54) **DISPOSITIF DE PREHENSION**
GREIFVORRICHTUNG
GRIP DEVICE

(30) Priorité: 29.03.2018 FR 1852728
(43) Date de publication de la demande: 17.02.2021
(73) Titulaire: ECM GREENTECH, 38100 Grenoble (FR)
(72) Inventeur: LAUNAY, Mickael, 34170 CASTELNAU-LE-LEZ (FR); DUVIVIER, Pierre Yves, 38029 GRENOBLE CEDEX 2 (FR); BENSAID, Chakib, 34170 CASTELNAU-LE-LEZ (FR)
(74) Mandataire: Cabinet Beaumont
(86) Numéro de dépôt international: PCT/FR2019/050592
(87) Numéro de publication internationale: WO 2019/186025

(56) Documents cités:
- WO-A1-89/12907
- WO-A1-2012/144120
- JP-A- 2015 103 648
- US-A- 6 099 056
- US-A1- 2007 290 517

## Description

La présente demande de brevet revendique la priorité de la demande de brevet français FR18/52728 qui sera considérée comme faisant partie intégrante de la présente description.

### Domaine

La présente demande concerne un dispositif de préhension pour la manipulation d'objets minces.

### Exposé de l'art antérieur

Un dispositif de préhension d'objets minces mettant en oeuvre le principe de Bernoulli est décrit dans le brevet US4969676. Un tel dispositif peut notamment être utilisé pour la manipulation de plaquettes de silicium destinées à la fabrication de cellules photovoltaïques.

Le dispositif de préhension comprend au moins une buse d'éjection d'air adaptée à former un film d'air entre le dispositif de préhension et l'objet mince à manipuler. L'écoulement d'air crée par effet Bernoulli une dépression entraînant le maintien de l'objet contre le dispositif de préhension, l'ensemble comprenant le dispositif de préhension et l'objet mince appliqué contre celui-ci pouvant être déplacé. Le dispositif de préhension peut comprendre plusieurs buses pour permettre le déplacement simultané de plusieurs objets minces.

Pour certaines applications, il est nécessaire que le dispositif de préhension soit de petites dimensions, notamment une faible épaisseur, pour pouvoir déplacer l'objet à manipuler dans un espace confiné. A titre d'exemple, le traitement de plaquettes de silicium pour la fabrication de cellules photovoltaïques peut comprendre la mise en place des plaquettes sur un dispositif de maintien comprenant un empilement de plateaux, plusieurs plaquettes pouvant être disposées sur chaque plateau. Il est alors nécessaire que le dispositif de préhension puisse pénétrer avec les plaquettes manipulées entre deux plateaux pour déposer les plaquettes sur l'un des plateaux ou saisir les plaquettes présentes sur l'un des plateaux.

Le document US6099056 décrit un dispositif de préhension d'un objet.

### Résumé

Un objet d'un mode de réalisation vise un dispositif de préhension d'objets minces qui soit lui-même mince.

Un objet d'un mode de réalisation vise un dispositif de préhension d'objets minces mettant en oeuvre le principe de Bernoulli.

Un objet d'un mode de réalisation vise un dispositif de préhension permettant la manipulation simultanée d'au moins deux objets minces.

Un objet d'un mode de réalisation vise un dispositif de préhension dont le procédé de fabrication est simple.

Un objet d'un mode de réalisation vise un dispositif de préhension dont le coût de fabrication est réduit.

Ainsi, un mode de réalisation prévoit un dispositif de préhension d'au moins un objet comprenant un préhenseur destiné à venir en contact avec ledit objet, le préhenseur comprenant :
un support comprenant une plaque ayant des première et deuxième faces opposées comprenant des premières ouvertures s'étendant dans la plaque depuis la première face seulement sur une partie de l'épaisseur de la plaque et des deuxièmes ouvertures s'étendant dans la plaque depuis la deuxième face seulement sur une partie de l'épaisseur de la plaque, chaque première ouverture communiquant avec au moins l'une des deuxièmes ouvertures ;
au moins une buse à effet Bernoulli d'éjection d'air fixée au support ; et
au moins un tube relié à la buse et disposé dans les premières et deuxièmes ouvertures.

Selon un mode de réalisation, le préhenseur comprend au moins deux buses, et au moins deux tubes disposés dans les premières et deuxièmes ouvertures, chaque tube étant relié à l'une des buses.

Selon un mode de réalisation, le dispositif de préhension comprend une troisième ouverture traversant complètement la plaque de la première face à la deuxième face et délimitant des premier et deuxième bras dans la plaque, au moins l'une desdites au moins deux buses étant fixée au premier bras et l'autre desdites au moins deux buses étant fixée au deuxième bras.

Selon un mode de réalisation, le support comprend une base reliée à la plaque et plus épaisse que la plaque.

Selon un mode de réalisation, le préhenseur comprend, pour chaque tube, un embout fixé à la base.

Selon un mode de réalisation, le dispositif de préhension comprend une barre reliant les deux bras du côté opposé à la base.

Selon un mode de réalisation, l'épaisseur de la plaque est comprise entre 5 mm et 10 mm.

Selon un mode de réalisation, le support est une pièce monobloc.

Selon un mode de réalisation, l'objet est un substrat semiconducteur destiné à la fabrication de cellules photovoltaïques.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en perspective, partielle et schématique, d'un mode de réalisation d'un dispositif de préhension ;
les figures 2 à 5 sont respectivement une vue en perspective, une vue de dessus, une vue de dessous et une vue en coupe d'un mode de réalisation du préhenseur du dispositif de préhension représenté en figure 1 ;
la figure 6 est une vue agrandie de la figure 5 ; et
les figures 7A à 7D illustrent des étapes successives d'un mode de réalisation d'un procédé de chargement de plaquettes de silicium sur des plateaux.

### Description détaillée

De mêmes éléments ont été désignés par de mêmes références aux différentes figures et, de plus, les diverses figures ne sont pas tracées à l'échelle. Par souci de clarté, seuls les éléments qui sont utiles à la compréhension des modes de réalisation décrits ont été représentés et sont détaillés. En particulier, les moyens de commande d'un robot articulé sont bien connus de l'homme du métier et ne sont pas décrits.

Dans la description qui suit, lorsque l'on fait référence à des qualificatifs de position relative, tels que les termes "dessus", "dessous", etc., il est fait référence à la direction verticale. Sauf précision contraire, les expressions "sensiblement" et "de l'ordre de" signifient à 10 % près, de préférence à 5 % près.

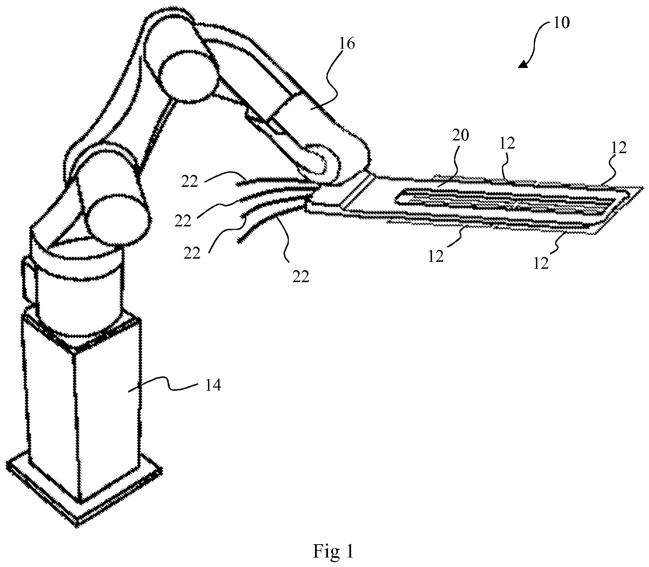

La figure 1 est une vue en perspective, partielle et schématique, d'un mode de réalisation d'un dispositif de préhension 10 d'objets minces 12, par exemple des plaquettes de silicium. Le dispositif de préhension 10 comprend un socle 14, un bras articulé 16 monté sur le socle 14 portant à une extrémité un préhenseur 20. Le préhenseur 20 est relié par des conduites 22 à des sources de fourniture d'air comprimé non représentées. Dans le présent mode de réalisation, le préhenseur 20 est adapté à déplacer simultanément quatre plaquettes 12. Le bras articulé 16 et les sources d'air comprimé sont commandés par un mode de commande non représenté comprenant par exemple un ordinateur.

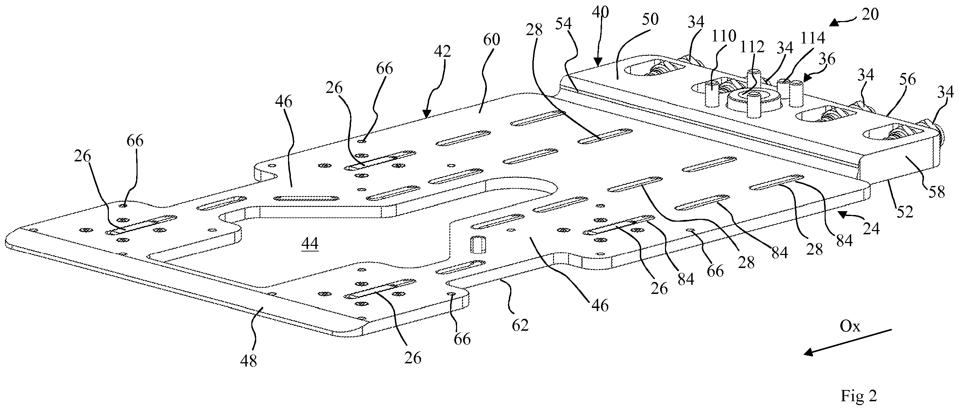

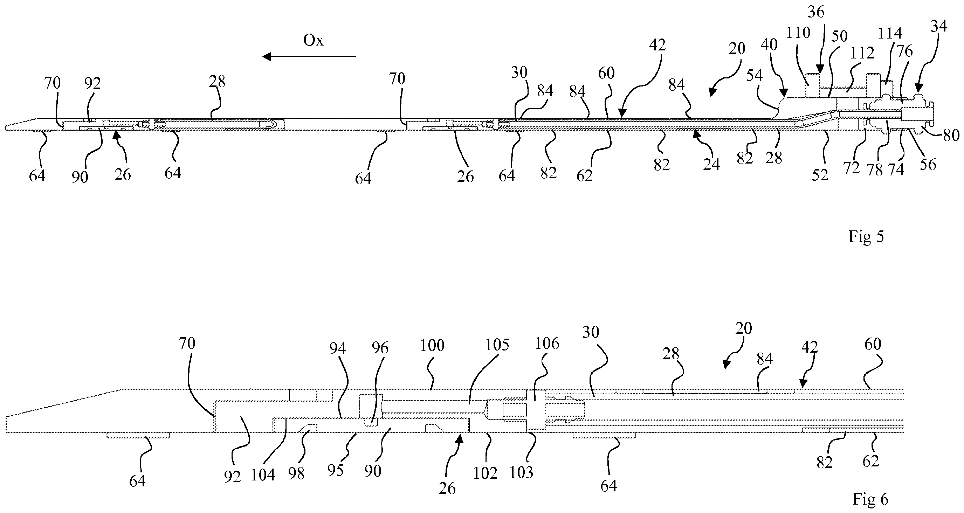

Les figures 2 à 5 sont respectivement une vue en perspective, une vue de dessus, une vue de dessous et une vue en coupe d'un mode de réalisation du préhenseur 20 du dispositif de préhension 10 représenté en figure 1. La figure 6 est une vue agrandie de la figure 5.

Le préhenseur 20 comprend :
- un support 24 ;
- quatre buses 26 d'éjection d'air sous pression maintenues par le support 24 ;
- pour chaque buse 26, un tube 28 souple d'apport d'air sous pression, le tube 28 s'étendant dans le support 24 et comprenant deux extrémités 30 et 32, le tube 28 étant connecté à l'extrémité 30 à la buse 26 ;
- pour chaque buse 26, un embout 34 connecté à l'extrémité 32 du tube 28 et connecté à l'une des conduites 22, non représentées sur les figures 2 à 6 ; et
- un système 36 de fixation du préhenseur 20 au bras articulé 16, non représenté sur les figures 2 à 6.

Le support 24 correspond à une pièce monobloc. Le support 24 peut être en métal, par exemple en aluminium.

Le support 24 comprend :
- une base 40 ;
- une plaque 42 s'étendant depuis la base 40 et traversée par une ouverture 44 délimitant dans la plaque deux bras 46 s'étendant l'un à côté de l'autre et séparés latéralement par l'ouverture 44 ; et
- une barre de liaison 48 prolongeant la plaque 42 et reliant les extrémités des bras 46 opposées à la base 40.

La base 40 est inscrite dans un parallélépipède à base rectangulaire dont le grand côté varie de 180 mm à 240 mm et dont le petit côté varie de 40 mm à 80 mm. L'épaisseur de la base 40 varie de 10 mm à 20 mm. La base 40 comprend deux faces opposées 50, 52 sensiblement planes, et des bords 54, 56, 58 reliant les deux faces 50, 52, en particulier un bord avant 54, un bord arrière 56 opposé au bord avant 54 et des bords latéraux 58 opposés. Les embouts 34 sont fixés à la base 40. Chaque embout 34 comprend une partie logée dans la base 40 et une partie qui se projette hors de la base 40 vers l'extérieur depuis le bord arrière 56. Le système 36 de fixation est situé dans la base 40 et sur la base 40. Le bras articulé 16 est fixé à la base 40 du côté de la face 50.

La plaque 42 est inscrite dans un parallélépipède à base rectangulaire dont le grand côté varie de 300 mm à 400 mm et dont le petit côté varie de 180 mm à 250 mm. L'épaisseur de la plaque 42 varie de 5 mm à 10 mm. La plaque 42 comprend deux faces opposées 60, 62 sensiblement planes. La plaque 42 prolonge la base 40 du côté du bord avant 54 de la base 40. La face 62 de la plaque 42 est sensiblement coplanaire avec la face 52 de la base 40 tandis que la face 60 de la plaque 42 n'est pas coplanaire avec la face 50 de la base 40 mais est parallèle à la face 50. Pour chaque buse 26, le support 20 comprend des plots 64, quatre plots 64 étant représentés pour chaque buse 26 sur les figures, qui se projettent depuis la face 62 de la plaque 42 autour de la buse 26. Selon un mode de réalisation, la hauteur en saillie de chaque plot 64 par rapport à la face 62 varie de 0 mm à 2 mm. Selon un mode de réalisation, chaque plot 64 correspond à la tête d'une vis 66 vissée au travers de la plaque 42, les vis 66 étant en un matériau non contaminant pour l'objet mince 12 transporté, par exemple en polyétheréthercétone (PEEK). On appelle direction Ox la direction parallèle aux faces 60 et 62 et dirigée de la base 40 vers la barre de liaison 48.

La barre de liaison 48 peut former un nez dont la pointe est orientée vers l'extérieur du préhenseur 20.

Chaque tube 28 est par exemple en téflon, en polyuréthane, en polyoléfine ou en polyamide. Selon un mode de réalisation, chaque tube 28 a un diamètre extérieur compris entre 3 mm et 6 mm et un diamètre intérieur compris entre 1,5 mm et 4 mm.

La plaque 42 comprend des évidements 70 qui s'étendent dans la plaque 42 depuis la face 52 et dans lesquels sont logées les buses 26.

La base 40 comprend, pour chaque embout 34, une ouverture 72 qui traverse complètement la base 40, de la face 50 jusqu'à la face 52. La base 40 comprend, en outre, pour chaque embout 34, une ouverture 74 qui pénètre dans la base 40 depuis le bord arrière 56 et qui débouche dans l'ouverture 72. L'embout 34 comprend une portion centrale 76 se prolongeant par des première et deuxième portions d'extrémité 78, 80. La portion centrale 76 est logée dans l'ouverture 74, la première portion d'extrémité 78 est située dans l'ouverture 72 et la deuxième portion d'extrémité 80 est située à l'extérieur du support 24.

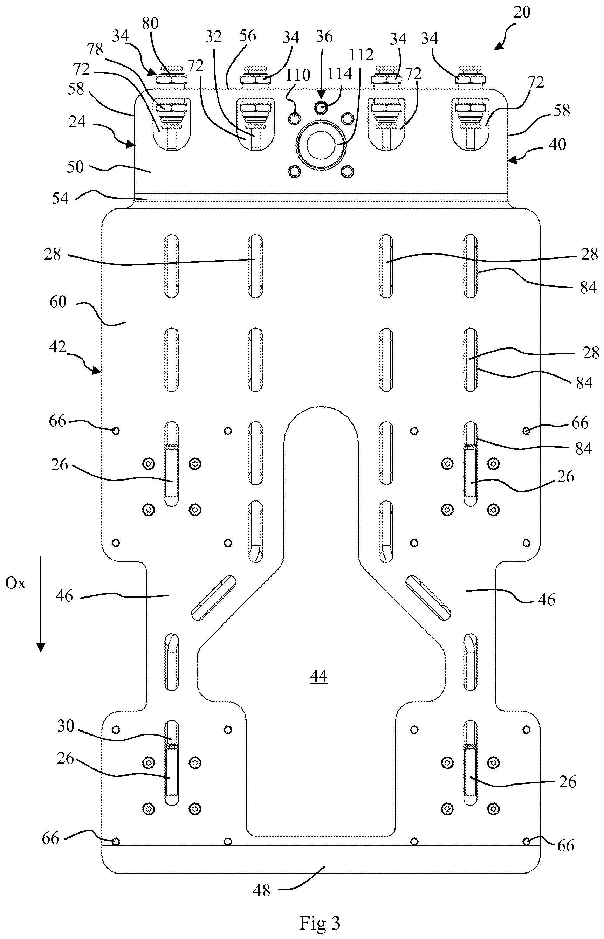

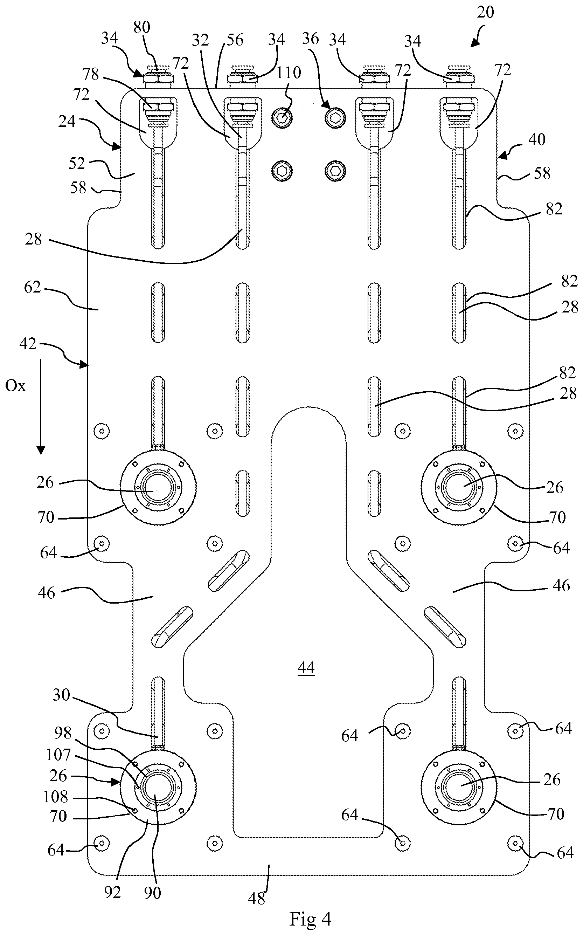

Le support 24 comprend en outre des ouvertures 82, 84 qui forment des passages pour les tubes 28. Plus précisément, pour chaque tube 28, le support 24 comprend des premières ouvertures 82 qui s'étendent dans le support 24 depuis la face 52 de la base 40 sur plus de la moitié de l'épaisseur de la base 40 ou depuis la face 62 de la plaque 42 sur plus de la moitié de l'épaisseur de la plaque 42 et des deuxièmes ouvertures 84 qui s'étendent dans le support 24 depuis la face 60 de la plaque 42 sur plus de la moitié de l'épaisseur de la plaque 42. Chaque première et deuxième ouverture 82, 84 a dans la vue de dessus de la figure 3 ou dans la vue de dessous de la figure 4 une forme oblongue. Chaque première ouverture 82 communique, à au moins l'une de ses extrémités selon la direction Ox, avec l'une des ouvertures 84 de façon à former, pour chaque tube 28, une succession de premières et deuxièmes ouvertures 82, 84 formant un passage pour le tube 28 depuis l'une des ouvertures 72 jusqu'à l'un des évidements 70.

Comme cela est notamment visible en figure 6, chaque buse 26 comprend deux pièces 90, 92 :
une pièce centrale 90 correspondant à une buse à effet Bernoulli ; et
une pièce intermédiaire 92 interposée entre la pièce centrale 90 et la plaque 42.

La pièce centrale 90 est une pièce cylindrique comprenant deux faces planes opposées 94, 95 et comprenant une entrée d'air 96 sur la face 94 et une sortie d'air 98 sur la face 95. La sortie d'air 98 est reliée à l'entrée d'air 96 par des conduites, non visibles sur les figures, adaptées à guider l'écoulement d'air de façon que le flux d'air s'échappant par la sortie 98 soit sensiblement tangent à la face 95. De façon avantageuse, le vecteur vitesse du flux d'air qui s'échappe de la pièce centrale 90 comprend une composante non radiale par rapport à l'axe de la pièce centrale 90, c'est-à-dire que le flux d'air tend à s'échapper de la pièce centrale 90 selon un mouvement tourbillonnaire. La pièce centrale 90 est par exemple réalisée en aluminium, en acier, en acier inoxydable ou en plastique.

La pièce intermédiaire 92 est une pièce comprenant deux faces planes opposées 100, 102 et un bord latéral 103 reliant les faces 100 et 102. La pièce intermédiaire 92 comprend un évidement 104 s'étendant dans la pièce 92 depuis la face 102. La pièce centrale 90 est logée dans l'évidement 104. La pièce intermédiaire 92 comprend une conduite 105 qui débouche à une extrémité sur l'évidement 104 en vis-à-vis de l'entrée d'air 98 de la pièce centrale 90 et qui débouche à une extrémité opposée sur le bord latéral 103. Un raccord 106 relie le tube 28 à la conduite 105, le raccord pénétrant en partie dans le tube 28 et en partie dans la conduite 105. La pièce centrale 90 est fixée à la pièce intermédiaire 92 par des vis 107 et la pièce intermédiaire 92 est fixée à la plaque 42 par des vis 108. La face 95 de la pièce centrale 90, la face 102 de la pièce intermédiaire 92 et la face 52 de la plaque 42 sont sensiblement coplanaires. La pièce intermédiaire 92 est par exemple réalisée en aluminium, en acier, en acier inoxydable ou en plastique. Le raccord 106 est par exemple réalisé en aluminium, en acier, en acier inoxydable ou en plastique.

Selon un mode de réalisation, le système 36 de fixation comprend des vis de fixation 110 traversant la base 40 de la face 50 à la face 52 et destinées à être vissées dans le bras articulé 16, non représenté. Le système de fixation 36 peut en outre comprendre un pion de centrage 112 se projetant depuis la face 50 de la base 40 et destiné à coopérer avec un évidement de forme complémentaire du bras articulé 16. Ceci permet de positionner automatiquement le préhenseur 20 par rapport au bras articulé 16 lors du montage du préhenseur 20 sur le bras articulé 16. Le système de fixation 36 peut en outre comprendre un plot 114 se projetant depuis la face 50 de la base 40 et destiné à coopérer avec un évidement de forme complémentaire du bras articulé 16. Le plot 114 joue le rôle d'un détrompeur lors du montage du préhenseur 20 sur le bras articulé 16 pour assurer que le préhenseur 20 est monté avec la bonne orientation par rapport au bras articulé 16.

Un mode de réalisation d'un procédé de fabrication du préhenseur 20 comprend l'usinage de la forme extérieure de la base 40, de la plaque 42 et de la barre de liaison 48 dans un bloc unique du matériau composant le préhenseur 20 et l'usinage des ouvertures 44, 72, 74, 82, 84 et des logements 70 dans la base 40 et la plaque 42. Les tubes 28 peuvent alors être introduits dans les ouvertures 82 et 84. Le procédé peut alors comprendre la fixation des embouts 34 aux extrémités des tubes 28, la fixation des buses 26 dans les logements 70 et la fixation des plots 64 à la plaque 42.

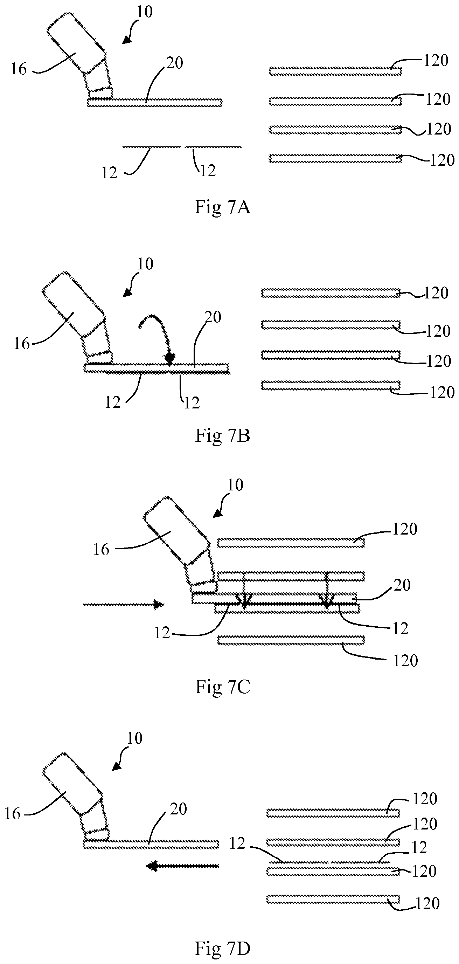

Les figures 7A à 7D illustrent des étapes successives d'un mode de réalisation d'un procédé de chargement d'objets minces 12, par exemple des plaquettes de silicium, sur des plateaux 120. Chaque buse 26 permet la préhension d'une plaquette de silicium 12 qui a, par exemple, un poids compris entre 10 g et 20 g.

A titre d'exemple, les plateaux 120 sont maintenus par un dispositif de maintien, non représenté, et disposés selon un empilement de plateaux, le dispositif de maintien maintenant un écart entre chaque paire de plateaux 120 adjacents qui varie, par exemple, de 8 mm à 100 mm.

Le procédé peut comprendre les étapes suivantes :
les plaquettes 12 à disposer sur l'un des plateaux 120 sont apportées à proximité du dispositif de préhension 10 (figure 7A) ;
le dispositif de préhension 10 est actionné de façon à amener le préhenseur 20 en contact avec les plaquettes 12 (figure 7B), les plots 64 assurant le maintien d'un interstice entre chaque plaquette 12 et la plaque 42 du préhenseur 20. L'éjection d'air par les buses 26 est alors commandée, par exemple à un débit de l'ordre de 120 l/min à une pression de l'ordre de 0,4 MPa, ce qui entraîne par effet Bernoulli le "collage" des plaquettes 12 contre le préhenseur 20 ;
le dispositif de préhension 10 est actionné de façon à placer le préhenseur 20 au-dessus du plateau 120 sur lequel doivent être déposées les plaquettes 12 (figure 7C). La faible épaisseur du préhenseur 20 permet son introduction entre deux plateaux 120. La longueur de la plaque 42 est adaptée pour que le préhenseur 20 puisse être introduit à la bonne position entre deux plateaux 120. La forme effilée de la barre 48 permet de faciliter l'introduction du préhenseur 20 dans l'interstice entre deux plateaux 120 ; et
l'éjection d'air par les buses 26 est alors arrêtée, ce qui entraîne le dépôt par gravité des plaquettes sur le plateau 120 sous-jacent (figure 7D) . Le dispositif de préhension 10 est alors actionné pour retirer le préhenseur 20.

L'ensemble comprenant les plateaux 120 et les plaquettes 12 de silicium peut alors être placé dans un dispositif de traitement, par exemple un dispositif de traitement assisté par plasma adapté à la mise en oeuvre d'un procédé de dépôt chimique en phase vapeur avec assistance par plasma ou PECVD (sigle anglais pour Plasma Enhanced Chemical Vapor Déposition), notamment pour le dépôt d'une couche isolante électriquement sur une face des plaquettes de silicium. Toutefois, il est clair que la présente invention peut être mise en oeuvre avec tout type de dispositif de traitement.

Un avantage d'un mode de réalisation du dispositif de préhension 10 est que le support 24 est une pièce monobloc. Ceci permet de réduire les vibrations du support 24 par rapport à un support qui serait réalisé par l'assemblage de plusieurs pièces les unes aux autres. Ceci permet en outre de réduire les coûts de fabrication du préhenseur 20 puisque le support 24 est réalisé par une seule étape d'usinage et que la fabrication du support 24 ne comprend pas d'étape d'assemblage.

Un avantage d'un mode de réalisation du dispositif de préhension 10 est que le transport d'air jusqu'à chaque buse 26 est réalisé par un tube 28. Ceci permet de réduire les fuites d'air par rapport à un support dans lequel les conduites pour la circulation d'air seraient réalisées par l'assemblage de deux pièces comprenant chacune la moitié de la forme de chaque conduit.

Des modes de réalisation particuliers ont été décrits. Diverses variantes et modifications apparaîtront à l'homme de l'art. En particulier, la forme de l'ouverture 44 dépend des propriétés de tenue mécanique souhaitées pour le support 24, plus l'ouverture 44 étant réduite plus le support 24 étant rigide et plus la masse du support 24 étant importante.

## Revendications

1. Dispositif de préhension (10) d'au moins un objet (12) comprenant un préhenseur (20) destiné à venir en contact avec ledit objet, le préhenseur (20) comprenant :
un support (24) comprenant une plaque (42) ayant des première et deuxième faces opposées (60, 62) comprenant des premières ouvertures (84) s'étendant dans la plaque (42) depuis la première face (60) seulement sur une partie de l'épaisseur de la plaque (42) et des deuxièmes ouvertures (82) s'étendant dans la plaque (42) depuis la deuxième face (62) seulement sur une partie de l'épaisseur de la plaque(42), chaque première ouverture (84) communiquant avec au moins l'une des deuxièmes ouvertures (82) ;
au moins une buse (26) à effet Bernoulli d'éjection d'air fixée au support (24) ; **caractérisé en ce que**
au moins un tube (28) relié à la buse (26) et disposé dans les premières et deuxièmes ouvertures.

2. Dispositif de préhension (10) selon la revendication 1, dans lequel le préhenseur (20) comprend au moins deux buses (26), et au moins deux tubes (28) disposés dans les premières et deuxièmes ouvertures (82, 84), chaque tube étant relié à l'une des buses.

3. Dispositif de préhension (10) selon la revendication 2, comprenant une troisième ouverture (44) traversant complètement la plaque (42) de la première face (60) à la deuxième face (62) et délimitant des premier et deuxième bras (46) dans la plaque, au moins l'une desdites au moins deux buses (26) étant fixée au premier bras et l'autre desdites au moins deux buses étant fixée au deuxième bras.

4. Dispositif de préhension (10) selon la revendication 2 ou 3, dans lequel le support (24) comprend une base (40) reliée à la plaque (42) et plus épaisse que la plaque (42).

5. Dispositif de préhension (10) selon la revendication 4, dans lequel le préhenseur (20) comprend, pour chaque tube (28), un embout (34) fixé à la base (40).

6. Dispositif de préhension (10) selon la revendication 4 dans sa dépendance à la revendication 3, comprenant une barre (48) reliant les deux bras (46) du côté opposé à la base (40).

7. Dispositif de préhension (10) selon l'une quelconque des revendications 1 à 6, dans lequel l'épaisseur de la plaque (42) est comprise entre 5 mm et 10 mm.

8. Dispositif de préhension (10) selon l'une quelconque des revendications 1 à 7, dans lequel le support (24) est une pièce monobloc.

9. Dispositif de préhension (10) selon l'une quelconque des revendications 1 à 8, dans lequel l'objet (12) est un substrat semiconducteur destiné à la fabrication de cellules photovoltaïques.

## Patentansprüche

1. Aufnahmevorrichtung (10) zum Aufnehmen wenigstens eines Gegenstands (12), die einen Greifer (20) aufweist, der dazu bestimmt ist, mit dem Gegenstand in Kontakt zu kommen, wobei der Greifer (20) Folgendes aufweist:
einen Träger (24) aufweisend eine Platte (42) mit einer ersten und einer zweiten gegenüberliegenden Oberfläche (60, 62), wobei die Platte (42) erste Öffnungen (84) aufweist, die sich von der ersten Oberfläche (60) über nur einen Teil der Plattendicke in die Platte (42) erstrecken, und zweite Öffnungen (82), die sich von der zweiten Oberfläche (62) über nur einen Teil der Plattendicke in die Platte (42) erstrecken, wobei jede erste Öffnung (84) mit wenigstens einer der zweiten Öffnungen (82) in Verbindung steht;
wenigstens eine Bernoulli-Effekt-Luftausstoßdüse (26), die an dem Träger (24) befestigt ist; und
wenigstens ein Rohr (28), das mit der Düse (26) verbunden und in der ersten und zweiten Öffnung angeordnet ist.

2. Aufnahmevorrichtung (10) nach Anspruch 1, wobei der Greifer (20) wenigstens zwei Düsen (26) und wenigstens zwei Rohre (28) aufweist, die in der ersten und zweiten Öffnung (82, 84) angeordnet sind, wobei jedes Rohr mit einer der Düsen verbunden ist.

3. Aufnahmevorrichtung (10) nach Anspruch 2, mit einer dritten Öffnung (44), die die Platte (42) von der ersten Fläche (60) zur zweiten Fläche (62) durchgehend durchquert und einen ersten und einen zweiten Arm (46) in der Platte begrenzt, wobei wenigstens eine der wenigstens zwei Düsen (26) am ersten Arm und die andere der wenigstens zwei Düsen am zweiten Arm befestigt ist.

4. Aufnahmevorrichtung (10) nach Anspruch 2 oder 3, wobei der Träger (24) eine Basis (40) aufweist, die mit der Platte (42) verbunden und dicker als die Platte (42) ist.

5. Aufnahmevorrichtung (10) nach Anspruch 4, wobei der Greifer (20) für jedes Rohr (28) ein Endstück (34) aufweist, das an der Basis (40) befestigt ist.

6. Aufnahmevorrichtung (10) nach Anspruch 4 und Anspruch 3, aufweisend eine Stange (48), die die beiden Arme (46) auf der der Basis (40) gegenüberliegenden Seite verbindet.

7. Aufnahmevorrichtung (10) nach einem der Ansprüche 1 bis 6, wobei die Dicke der Platte (42) im Bereich von 5 mm bis 10 mm liegt.

8. Aufnahmevorrichtung (10) nach einem der Ansprüche 1 bis 7, wobei der Träger (24) einteilig ist.

9. Aufnahmevorrichtung (10) nach einem der Ansprüche 1 bis 8, wobei der Gegenstand (12) ein Halbleitersubstrat für die Herstellung von Photovoltaikzellen ist.

## Claims

1. A device (10) for picking up at least one object (12) comprising a gripper (20) intended to come into contact with said object, the gripper (20) comprising:
a support (24) comprising a plate (42) having first and second opposite surfaces (60, 62) comprising first openings (84) extending into the plate (42) from the first surface (60) across a portion only of the plate (42) thickness and second openings (82) extending into the plate (42) from the second surface (62) across a portion only of the plate (42) thickness, each first opening (84) communicating with at least one of the second openings (82);
at least one Bernoulli-effect air ejection nozzle (26) attached to the support (24); and
at least one pipe (28) connected to the nozzle (26) and arranged in the first and second openings.

2. The pick-up device (10) of claim 1, wherein the gripper (20) comprises at least two nozzles (26) and at least two pipes (28) arranged in the first and second openings (82, 84), each pipe being connected to one of the nozzles.

3. The pick-up device (10) of claim 2, comprising a third opening (44) thoroughly crossing the plate (42) from the first surface (60) to the second surface (62) and delimiting first and second arms (46) in the plate, at least one of said at least two nozzles (26) being attached to the first arm and the other one of said at least two nozzles being attached to the second arm.

4. The pick-up device (10) of claim 2 or 3, wherein the support (24) comprises a base (40) coupled to the plate (42) and thicker than the plate (42).

5. The pick-up device (10) of claim 4, wherein the gripper (20) comprises, for each pipe (28), an end piece (34) attached to the base (40).

6. The pick-up device (10) of claim 4 and of claim 3, comprising a bar (48) coupling the two arms (46) on the side opposite to the base (40).

7. The pick-up device (10) of any of claims 1 to 6, wherein the thickness of the plate (42) is in the range from 5 mm to 10 mm.

8. The pick-up device (10) of any of claims 1 to 7, wherein the support (24) is one piece.

9. The pick-up device (10) of any of claims 1 to 8, wherein the object (12) is a semiconductor substrate intended for the manufacturing of photovoltaic cells.
